# EUROPÄISCHE PATENTANMELDUNG

(11) **EP 2 405 279 A2**
(43) Veröffentlichungstag der Anmeldung: **11.01.2012**
(21) Anmeldenummer: 11003952.6
(22) Anmeldetag: 13.05.2011
(51) Int. Cl.: G01R 31/08

(54) **Verfahren und Vorrichtung zur Ortung von Kabelfehlern**

(30) Priorität: 10.07.2010 DE 102010026815
(71) Anmelder: Hagenuk KMT Kabelmesstechnik GmbH, 01471 Radeburg (DE); Technische Universität Dresden, 01069 Dresden (DE)
(72) Erfinder: Kordon, Ulrich, Dr.-Ing., 01239 Dresden (DE); Kürbis, Steffen, Dipl.-Ing., 01156 Dresden (DE); Wolff, Matthias, Dr.-Ing., 02826 Görtlitz (DE); Küttner, Marco, D-01159 Dresden (DE); Stephan, Marco, D-01129 Dresden (DE); Berth, Torsten, D-01468 Moritzburg (DE)
(74) Vertreter: Hansmann, Dierk

(57) **Zusammenfassung**

Es wird ein Verfahren und eine Vorrichtung zur Ortung von Fehlern in Kabeln beschrieben, die insbesondere zur Übertragung und Verteilung von elektrischer Energie dienen und im Erdreich verlegt sind, und zwar mittels eines an einem Fehlerort des Kabels erzeugten akustischen Signals, das insbesondere ein durch einen elektrischen Impuls ausgelöstes Überschlags- oder Entladungsgeräusch ist. Solche akustischen Signale sind oftmals mit Störgeräuschen überlagert, die ihre Identifizierung und somit auch eine Lokalisierung des Fehlerortes erschweren oder unmöglich machen können. Erfindungsgemäß wird der Einfluss von Störgeräuschen dadurch zumindest minimiert, dass das am Fehlerort erzeugte und mit den Störgeräuschen überlagerte akustische Signal durch Vergleichen mit bestimmten Signalmustern oder Merkmalsätzen identifiziert wird.

## Beschreibung

Die Erfindung betrifft ein Verfahren und eine Vorrichtung zur Ortung von Fehlern in Kabeln, die insbesondere zur Übertragung und Verteilung von elektrischer Energie dienen und im Erdreich verlegt sind, mittels eines an einem Fehlerort des Kabels erzeugten akustischen Signals, das insbesondere ein durch einen elektrischen Impuls ausgelöstes Überschlags- oder Entladungsgeräusch ist.

Zu unterscheiden ist bei Kabelfehlern im Wesentlichen zwischen einem Erdschluss, bei dem ein oder mehrere Leiter des Kabels über eine fehlerhafte leitende Verbindung mit Erdpotential verbunden sind, einem Kurzschluss, bei dem zwei oder mehrere Leiter des Kabels hoch- oder niederohmig miteinander verbunden sind, einer Unterbrechung, bei der ein oder mehrere Leiter innerhalb des Kabels unterbrochen sind, sowie Kombinationen dieser Fehlerarten.

Bei der Ortung solcher Fehler ist zu unterscheiden zwischen der Vorortung, mit der eine mehr oder weniger genaue Entfernung des Fehlerortes von einem Kabelanfang ermittelt und ggf. eine Identifizierung des fehlerhaften Kabels vorgenommen werden kann, sowie der Nachortung, mit der eine punktgenauen Lokalisierung des Fehlerortes erfolgt.

Zur Vor- und Nachortung sind je nach Art des Kabelfehlers verschiedene Verfahren bekannt. Eine wesentliche Grundlage solcher Verfahren sind Reflektionsmessungen, bei denen ein sich über die Leitung ausbreitender elektrischer Impuls an dem Fehlerort reflektiert wird und die Entfernung des Fehlerortes zu der Stelle der Einspeisung des Impulses anhand der Zeitdauer zwischen der Einspeisung des Impulses und dem Empfangen des reflektierten Impulses und damit dessen Laufzeit berechnet werden kann. Darüber hinaus kann mit energiereicheren Impulsen ein elektrischer Überschlag oder ein Lichtbogen an dem Fehlerort erzeugt werden, der zu einem akustischen Entladungsgeräusch führt, das mittels eines akustischen Sensors an der Erdoberfläche aufgenommen und über dessen Intensität der Fehlerort lokalisiert werden kann. Schließlich ist es auch möglich, die Laufzeit des akustischen Signals und insbesondere die Zeitdauer zwischen der Detektion des durch den elektrischen Impuls erzeugten elektromagnetischen Feldes und der Detektion des durch diesen Impuls ausgelösten akustischen Signals an einem Messort auszuwerten.

Dabei hat sich jedoch gezeigt, dass das tatsächlich empfangene akustische Signal (im Folgenden "Empfangssignal" genannt) nicht nur das am Fehlerort des Kabels erzeugte akustische Signal, sondern auch erhebliche akustische Störgeräusche wie sie z.B. durch Umwelteinflüsse (Wind, Regen) oder den Straßenverkehr oder Personen usw. hervorgerufen werden, enthalten kann, die die Identifizierung des an dem Fehlerort des Kabels erzeugten akustischen Signals erheblich erschweren bzw. stören und damit die Genauigkeit und Effizienz der Fehlerortung beeinträchtigen können.

Eine Aufgabe, die der Erfindung zugrunde liegt, besteht deshalb darin, ein Verfahren und eine Vorrichtung zur Ortung von Kabelfehlern mittels eines an einem Fehlerort des Kabels erzeugten akustischen Signals anzugeben, das/die gegen die oben genannten oder andere Störgeräusche wesentlich unempfindlicher ist und damit eine genauere und zuverlässigere Lokalisierung eines Fehlerortes möglich macht.

Gelöst wird diese Aufgabe gemäß Anspruch 1 mit einem Verfahren zur Ortung von Kabelfehlern mittels eines an einem Fehlerort des Kabels erzeugten akustischen Signals dadurch, dass ein Empfangssignal, das das an einem Fehlerort erzeugte akustische Signal beinhaltet, mit gespeicherten Signalmustern oder Merkmalen oder Merkmalsätzen von an einem Fehlerort erzeugten akustischen Signalen verglichen wird, um das Signal bei einer Übereinstimmung oder einer vorbestimmten Ähnlichkeit mit den Signalmustern oder Merkmalen oder Merkmalsätzen in dem Empfangssignal zu identifizieren.

Die Aufgabe wird ferner gemäß Anspruch 6 mit einer Vorrichtung gelöst, die eine Sensor- und Auswerteeinheit mit einem akustischen Sensor zum Erfassen eines akustischen Empfangssignals, das ein an einem Fehlerort eines Kabels erzeugtes akustisches Signal beinhaltet, sowie eine Vergleichseinheit mit einem Speicher aufweist, zum Vergleichen des Empfangssignals mit in dem Speicher gespeicherten Signalmustern oder Merkmalen oder Merkmalsätzen von an einem Fehlerort erzeugten akustischen Signalen, und zum Identifizieren des Signals in dem Empfangssignal, wenn das Signal mit den Signalmustern oder Merkmalen oder Merkmalsätzen eine Übereinstimmung oder eine vorbestimmte Ähnlichkeit aufweist.

Ein Vorteil dieser Lösung besteht darin, dass auch subjektive Einflüsse des jeweiligen Benutzers auf die Erfassung des an dem Fehlerort ausgelösten akustischen Signals deutlich vermindert werden können. Damit kann die Genauigkeit der Lokalisierung des Fehlerortes wesentlich verbessert werden. Dies trifft insbesondere bei relativ starken äußeren akustischen Störsignalen und/oder einem noch relativ großen Abstand der genannten Vorrichtung von dem Fehlerort zu.

Die erfindungsgemäße Lösung ist insbesondere zur Nachortung eines Fehlerortes geeignet, wobei jedoch in Abhängigkeit von der Länge bzw. der Größe des betreffenden Kabelnetzes oder anderen Umstände auf eine Vorortung des Fehlerortes ggf. auch verzichtet bzw. die erfindungsgemäße Lösung auch zur Vorortung verwendet werden kann.

Die Unteransprüche haben vorteilhafte Weiterbildungen der Erfindung zum Inhalt.

Die Ausführungsformen gemäß den Ansprüchen 2 bis 4 sowie 7 bis 9 ermöglichen nicht nur eine Ortung des Kabelfehlers anhand einer Intensität des an dem Fehlerort erzeugten akustischen Signals, sondern auch die Messung eines Abstandes zwischen einer erfindungsgemäßen Vorrichtung und dem Fehlerort.

Die Ausführungsformen gemäß den Ansprüchen 5 und 10 beinhalten eine bevorzugte Vorverarbeitung des Empfangssignals, bevor es mit den gespeicherten Signalmustern oder Merkmalen oder Merkmalsätzen verglichen wird.

Weitere Einzelheiten, Merkmale und Vorteile der Erfindung ergeben sich aus der folgenden Beschreibung von beispielhaften und bevorzugten Ausführungsformen der Erfindung anhand der Zeichnung. Es zeigt:
- Fig. 1: eine prinzipielle Anordnung verschiedener Komponenten zur akustischen Ortung eines Kabelfehlers;
- Fig. 2: ein zeitlicher Verlauf eines empfangenen akustischen Signals in zeitlicher Relation zum empfangenen elektromagnetischen Signal;
- Fig. 3: ein Prinzipschaltbild einer Ausführungsform einer erfindungsgemäßen Vorrichtung;
- Fig. 4: eine Darstellung zur Erläuterung eines akustischen Mustervergleichs gemäß der Erfindung und
- Fig. 5: ein Blockschaltbild einer Sensor- und Auswerteeinheit zur Anwendung in einem erfindungsgemäßen Verfahren.

Zur Erzeugung eines akustischen Signals an einem Fehlerort eines Kabels wird ein elektrisches Signal, vorzugsweise in Form eines Impulses, in das Kabel eingespeist, wobei die physikalische Parameter (Spannung, Strom, Frequenz, Dauer) des elektrischen Impulses in Abhängigkeit von der Art und Länge des Kabels sowie der Art des Fehlers so bemessen sind, dass es an dem Fehlerort einen elektrischen Überschlag, einen Durchschlag und/oder einen Lichtbogen erzeugt, der ein Entladungsgeräusch in Form eines akustischen Signals mit einer zur nachfolgend beschriebenen Erfassung ausreichenden Intensität auslöst.

Die erfindungsgemäße Lokalisierung eines Fehlerortes beruht auf der zeitlichen Dauer bzw. Verzögerung zwischen der Erfassung des durch den elektrischen Impuls erzeugten elektromagnetischen Signals und der Erfassung des dadurch ausgelösten akustischen Signals an einer Stelle in der Umgebung des Fehlerortes. Zur Erfassung der beiden Signale und zur Ermittlung der genannten zeitlichen Dauer dient eine vorzugsweise mobile Sensor- und Auswerteeinheit mit einem akustischen sowie einem elektromagnetischen bzw. MagnetfeldSensor. Der Abstand zu dem Fehlerort ist dabei um so geringer, je kürzer diese zeitliche Dauer ist. Direkt an dem Fehlerort bzw. am Erdboden über dem Fehlerort weist die zeitliche Dauer ein deutliches Minimum auf, das im Wesentlichen durch die Tiefe bestimmt ist, in der das Kabel im Erdboden verlegt ist.

Sofern nicht nur die zeitliche Dauer und deren Minimum sondern auch die tatsächliche Entfernung der Sensor- und Auswerteeinheit zu dem Fehlerort ermittelt und ausgewertet werden soll, ist zu deren Berechnung die Ausbreitungsgeschwindigkeit des Schalls im Erdboden heranzuziehen.

Die Lokalisierung des fehlerhaften Kabels ist durch Anzeige der Magnetfeldintensität an der Sensor- und Auswerteeinheit möglich, da diese senkrecht über dem Kabel am größten ist. Das betreffende Magnetfeld wird ebenfalls durch den in das fehlerhafte Kabel eingespeisten elektrischen Impuls erzeugt.

Beispielsweise kann zur Erzeugung des elektrischen Impulses ein Stoßgenerator verwendet werden, der im Wesentlichen eine Hochspannungsquelle und einen Hochleistungs-Kondensatorblock aufweist, der mittels der Hochspannungsquelle auf eine erforderliche Impulsspannung aufgeladen wird. Wenn die erforderliche Impulsspannung (je nach Art des Kabels und nach Art des Fehlers bis zu einigen 100 kV) erreicht ist, wird die in dem Kondensatorblock gespeicherte Energie über ein Schaltsystem in Form eines elektrischen Impulses (energetische Wanderwelle) in das zu prüfende Kabel eingespeist. Der sich entlang des Kabels ausbreitende Impuls erzeugt dann an dem Fehlerort einen elektrischen Durchschlag, einen Spannungsüberschlag und/oder einen Lichtbogen und löst damit das akustische Signal aus, das sich im Wesentlichen im Erdboden ausbreitet und an der Erdoberfläche, ebenso wie das durch den elektrischen Impuls erzeugte elektromagnetische Signal, mittels der genannten Sensor- und Auswerteeinheit erfasst werden kann.

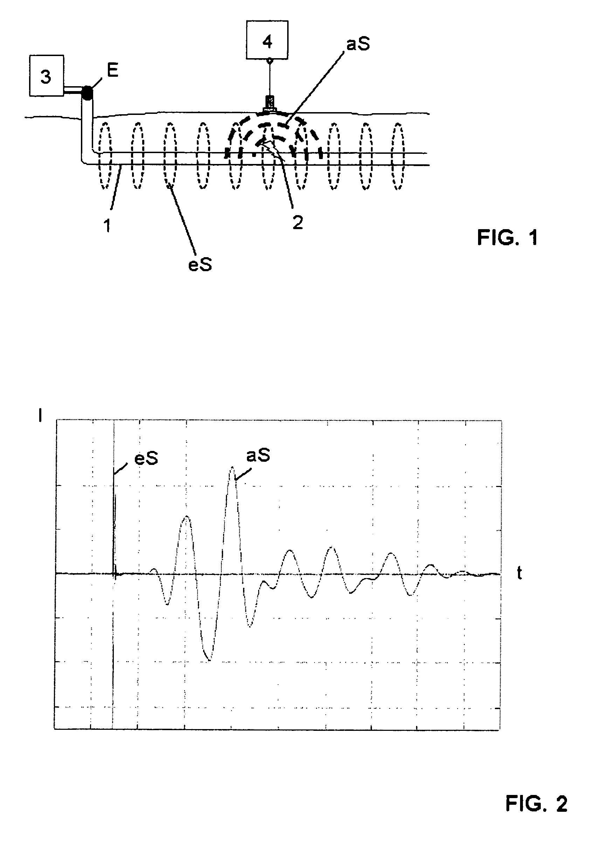

Eine entsprechende Anordnung ist schematisch in Figur 1 dargestellt.

Ein unterirdisch verlegtes Kabel 1 weist an einem zu ermittelnden Ort 2 einen Fehler auf. Das Kabel 1 wird an einer Einspeisestelle E mit einem Stoßgenerator 3 verbunden, mit dem ein elektromagnetisches Signal eS, vorzugsweise in Form eines elektromagnetischen Impulses, in das Kabel 1 eingespeist wird. Entlang oder in der Umgebung des Kabels befindet sich an der Erdoberfläche eine Sensor- und Auswerteeinheit 4 mit dem akustischen und dem elektromagnetischen (Magnetfeld-) Sensor, mit der der elektrische Impuls und das dadurch ausgelöste akustische Signal aS erfasst und die zeitliche Dauer zwischen beiden Signalen berechnet werden kann.

Ein typischer zeitlicher Verlauf dieser beiden Signale ist schematisch im Diagramm der Figur 2 dargestellt, wobei auf der horizontalen Achse die Zeit t und auf der vertikalen Achse die Signalamplitude I aufgetragen ist. Der elektromagnetische Impuls eS hat eine im Vergleich zum akustischen Signal aS sehr kurze Zeitdauer und eine relativ hohe Amplitude, während das akustische Signal aS üblicherweise ein oder zwei Maximalwerte aufweist und dann relativ schnell abklingt.

Die Messung der zeitlichen Dauer beginnt beim Erfassen des elektromagnetischen Impulses und endet vorzugsweise mit dem Erfassen eines definierten Wertes bzw. einer definierten Amplitude des akustischen Signals.

Wie eingangs bereits erläutert wurde, können akustische Störgeräusche, die insbesondere unmittelbar nach dem elektromagnetischen Impuls auftreten, die Erfassung des am Fehlerort erzeugten akustischen Signals beeinträchtigen oder unmöglich machen. Dies ist insbesondere dann der Fall, wenn sich die Sensor- und Auswerteeinheit noch in einer relativ großen Entfernung von dem Fehlerort befindet und/oder die akustischen Störgeräusche sehr intensiv sind, da in diesen Fällen insbesondere bei der Signalmessung mittels amplitudenbezogener Triggerschwellen Fehler auftreten können.

Erfindungsgemäß wird deshalb das mit der Sensor- und Auswerteeinheit 4 aufgenommene akustische Gesamt-Signal (das eine Mischung aus dem am Fehlerort erzeugten akustischen Signal und den Störgeräuschen darstellt und im Folgenden als "Empfangssignal" bezeichnet wird) im Hinblick auf das Auftreten bestimmter Signalmuster oder Merkmale oder Merkmalsätze, die typisch für ein an einem Fehlerort eines Kabels erzeugtes akustisches Signal sind, untersucht, um auf diese Weise das an dem Fehlerort erzeugte akustische Signal in dem aufgenommenen Eingangssignal zu identifizieren bzw. zu isolieren.

Diese Signalmuster, Merkmale oder Merkmalsätze können insbesondere bestimmte akustische Signalamplituden oder Signalfrequenzen oder andere Signalparameter enthalten oder darstellen oder auch in bestimmten Kombinationen und in einer bestimmten zeitlichen Abfolge auftreten. Diese für das an einem Kabelfehlerort erzeugte akustische Signal typischen Signalmuster, Merkmale oder Merkmalsätze werden z.B. durch die physikalischen Parameter des elektromagnetischen Signals, das das akustische Signal an dem Fehlerort auslöst, sowie die Art des Kabels und die Art des Fehlers beeinflusst oder bestimmt.

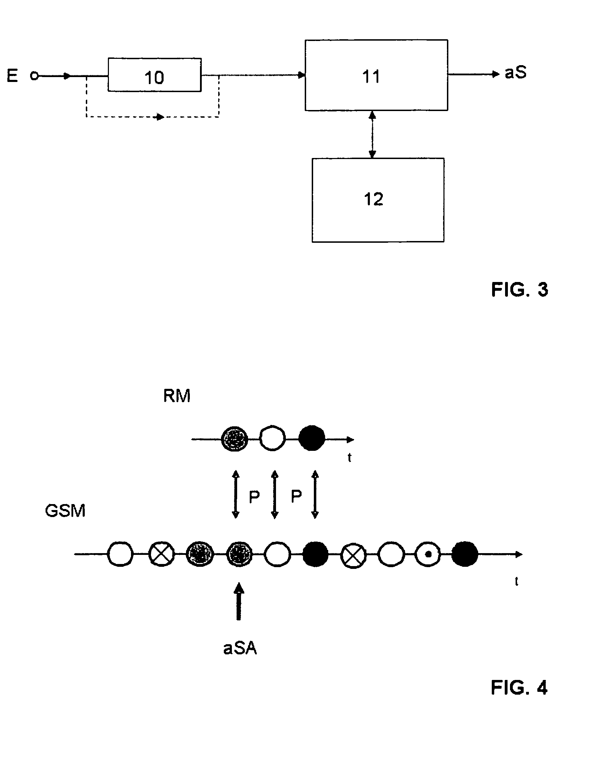

Das Prinzip der Erkennung der Signalmuster sowie die wesentlichen Komponenten einer entsprechenden Vorrichtung bzw. Schaltungsanordnung (die vorzugsweise Teil der Sensor- und Auswerteeinheit 4 ist) sind schematisch in Figur 3 dargestellt.

An einem Eingang E liegt das mit dem akustischen Sensor der Sensor- und Auswerteeinheit 4 aufgenommene Eingangssignal an. Dieses Eingangssignal wird einem Analysator 10 zugeführt, mit dem es in eine zeitliche Folge von einzelnen Signalmustern, Merkmalen oder in eine Folge von entsprechenden Merkmalsätzen der oben genannten Art zerlegt bzw. in diese transformiert wird, die jeweils für ein an einem Fehlerort erzeugtes akustisches Signal typisch bzw. kennzeichnend sein könnten.

Diese Signalmuster, Merkmale bzw. die Folge von Merkmalsätzen werden dann einer Vergleichseinheit 11 zugeführt, die mit einem Speicher 12 verbunden ist.

In dem Speicher 12 sind Signalmuster, Merkmale oder Merkmalsätze gespeichert, die gemäß obiger Erläuterung typisch für ein an einem Fehlerort eines Kabels erzeugtes akustisches Signal sind. Alternativ oder zusätzlich dazu ist es auch möglich, die typischen Signalmuster in Form von vorzugsweise heuristischen Modellen zu speichern, die z.B. in einem Lernvorgang mit geeigneten Testsignalen ermittelt werden. Solche Modelle bzw. anderer Signalmuster können auch noch während der Anwendung der Sensor- und Auswerteeinheit verfeinert bzw. gelernt werden. Zu diesem Zweck können Verfahren angewendet werden, wie sie z.B. im Bereich der automatischen Spracherkennung bekannt sind.

In der Vergleichseinheit 11 werden dann die Signalmuster, Merkmale oder Merkmalsätze des Empfangssignals im Hinblick auf das Auftreten von aus dem Speicher 12 ausgelesenen Signalmustern, Merkmalen oder Merkmalsätzen untersucht. Dies geschieht vorzugsweise im Wege der Ermittlung einer Ähnlichkeit bzw. eines Maßes an Übereinstimmungen zwischen dem oder den aus dem Speicher 12 ausgelesenen Signalmustern etc. und Abschnitten des Empfangssignals mit dem Ziel, denjenigen Abschnitt in dem Empfangssignal zu ermitteln, der mit einem der aus dem Speicher 12 ausgelesenen Signalmuster etc. die größte Ähnlichkeit aufweist.

Schematisch ist dieses Prinzip in Figur 4 entlang der Zeitachse t gezeigt. Das der Vergleichseinheit 11 zugeführte, gemäß obiger Erläuterung analysierte Eingangssignal ist in Form eines Eingangssignal-Musters GSM dargestellt, das eine Folge von Merkmalen bzw. einen Merkmalsatz beinhaltet. Dieses Muster GSM wird mit mindestens einem der aus dem Speicher 12 ausgelesenen Signalmuster (Referenzmuster RM) verglichen. Sobald eine Übereinstimmung oder zumindest ein vorbestimmtes Ähnlichkeitsmaß zwischen dem Referenzmuster RM und einem Abschnitt in dem Eingangssignal-Muster GSM gefunden wird (dieses ist in Figur 4 durch die Pfeile P angedeutet), wird der Beginn aSA des am Fehlerort ausgelösten akustischen Signals in dem Eingangssignal identifiziert bzw. festgelegt.

Bei diesem Vergleich können sowohl die Übereinstimmungen der Signaleigenschaften im Referenzmuster RM und im Eingangssignal-Muster GSM, als auch eventuelle nichtlineare zeitliche Unterschiede zwischen beiden berücksichtigt werden.

Alternativ zur Anwendung des in Figur 3 gezeigten Analysators 10 kann ggf. auf diesen auch verzichtet und der Vergleichseinheit 11 das Eingangssignal in nicht analysierter Weise zugeführt werden. Diese alternative Ausführung ist in Figur 3 mit gestrichelten Linien angedeutet. In diesem Fall sind in dem Speicher 12 entsprechende komplette akustische Signale wie sie an einem Fehlerort eines Kabels gemäß obiger Erläuterung erzeugt werden, als Referenz-Signale gespeichert, wobei in der Vergleichseinheit 11 dann ein Vergleich zwischen diesen beiden Signalen stattfindet.

Die beiden obigen Alternativen können sowohl in der analogen, als auch in der digitalen Ebene realisiert werden.

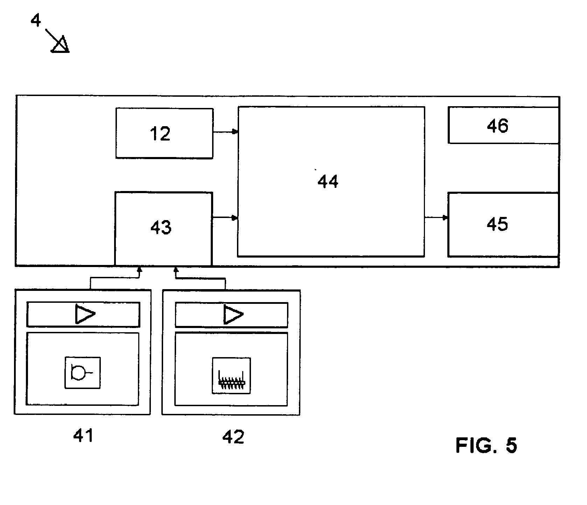

Figur 5 zeigt ein Blockschaltbild einer Sensor- und Auswerteeinheit 4 zur Durchführung der oben erläuterten Verfahren.

Die Sensor- und Auswerteeinheit 4 umfasst einen akustischen Sensor 41 zur Erfassung des oben erläuterten akustischen Eingangssignals sowie einen Magnetfeldsensor 42 zur Erfassung des oben erläuterten elektromagnetischen Signals. Die beiden Sensoren 41, 42 beinhalten jeweils einen Verstärker mit Filter zur analogen Verstärkung bzw. Vorfilterung der erfassten Sensorsignale.

Die Sensor- und Auswerteeinheit 4 weist weiterhin einen Analog/Digital-Wandler 43, einen Signalprozessor 44, einen Speicher 12, eine Anzeige- bzw. Ausgabeeinrichtung 45 sowie eine Stromversorgung 46 auf.

Die verstärkten und vorgefilterten analogen Sensorsignale werden über einen ersten bzw. einen zweiten Kanal dem Analog/Digital-Wandler 43 zugeführt und mit diesem in digitale Sensorsignale umgewandelt. Die digitalen Sensorsignale werden dann dem Signalprozessor 44 zugeführt, mit dem im Wesentlichen die im Zusammenhang mit Figur 2 erläuterten Funktionen des Analysators 10 und der Vergleichseinheit 11 realisiert werden. Zu diesem Zweck ist der Signalprozessor 44 mit dem ebenfalls im Zusammenhang mit Figur 2 erläuterten Speicher 12 verbunden.

Das gemäß der Beschreibung im Zusammenhang mit Figur 2 identifizierte akustische Signal, das an dem Fehlerort des Kabels mittels des elektrischen Impulses ausgelöst wird, wird ferner mittels des Signalprozessors 44 im Hinblick auf seine zeitliche Verzögerung gegenüber dem mit dem Magnetfeldsensor 42 erfassten elektromagnetischen Signal ausgewertet und entweder in Form einer Zeitangabe oder, nach Umrechnung auf der Grundlage der Schall-Ausbreitungsgeschwindigkeit, in Form einer Entfernungsangabe mittels der Anzeige- bzw. Ausgabeeinrichtung 45 angezeigt bzw. ausgegeben.

Darüber hinaus kann die Sensor- und Auswerteeinheit 4 auch so ausgestaltet sein, dass mit dem Magnetfeldsensor 42 auch die Stärke des erfassten elektromagnetischen Feldes zur Anzeige bzw. Ausgabe gebracht wird, um damit das den Fehlerort aufweisenden Kabel bzw. die betreffende Kabeltrasse zu identifizieren.

Die erfindungsgemäße Erkennung bzw. Identifizierung des an einem Fehlerort eines Kabels ausgelösten akustischen Signals kann nicht nur zu dem Zweck dienen, dessen Verzögerung gegenüber dem dieses Signal auslösenden elektromagnetischen Signale zu erfassen, um damit eine Entfernung von dem Fehlerort zu ermitteln. Denkbar ist z.B. auch, dass das akustische Signal nur im Hinblick auf seine Intensität ausgewertet wird, um damit den Fehlerort zu lokalisieren oder zum Beispiel Aufschluss über die Art des Kabelfehlers oder über andere Parameter zu erhalten.

Schließlich ist auch das erfindungsgemäße Prinzip der Erkennung bzw. Identifizierung des an einem Fehlerort eines Kabels ausgelösten akustischen Signals nicht nur dann anwendbar, wenn dieses Signal durch ein in das Kabel eingespeisten elektrischen Impuls und einen dadurch erzeugten Spannungsüberschlag, Durchschlag und/oder einen Lichtbogen, sondern auf andere Weise ausgelöst wird.

## Patentansprüche

1. Verfahren zur Ortung von Fehlern in Kabeln, die zur Übertragung und Verteilung von elektrischer Energie dienen und im Erdreich verlegt sind, mittels eines an einem Fehlerort des Kabels erzeugten akustischen Signals, wobei ein Empfangssignal, das das an dem Fehlerort erzeugte akustische Signal beinhaltet, mit gespeicherten Signalmustern oder Merkmalen oder Merkmalsätzen von an einem Fehlerort erzeugten akustischen Signalen verglichen wird, um das Signal bei einer Übereinstimmung oder einer vorbestimmten Ähnlichkeit mit den Signalmustern oder Merkmalen oder Merkmalsätzen in dem Empfangssignal zu identifizieren.

2. Verfahren nach Anspruch 1,
bei dem das akustische Signal mit einem in das Kabel eingespeisten elektrischen Impuls und einem dadurch an dem Fehlerort erzeugten Spannungsüberschlag, Durchschlag und/oder Lichtbogen ausgelöst wird.

3. Verfahren nach Anspruch 2,
bei dem der Fehlerort durch Ermittlung einer zeitlichen Verzögerung zwischen einer Erfassung des in das Kabel eingespeisten elektrischen Impulses und der Erfassung des an dem Fehlerort des Kabels erzeugten akustischen Signals geortet wird.

4. Verfahren nach Anspruch 3,
bei dem aus der zeitlichen Verzögerung und auf der Grundlage einer Ausbreitungsgeschwindigkeit des akustischen Signals eine Entfernung zwischen dem Ort der Erfassung des Empfangssignals und dem Fehlerort des Kabels ermittelt wird.

5. Verfahren nach Anspruch 2,
bei dem das Empfangssignal in eine zeitliche Folge von Merkmalen zerlegt wird, die mit den gespeicherten Signalmustern oder Merkmalen oder Merkmalsätzen verglichen werden.

6. Vorrichtung zur Durchführung eines Verfahrens nach einem der vorhergehenden Ansprüche,
mit einer Sensor- und Auswerteeinheit (4), die einen akustischen Sensor (41) zum Erfassen eines akustischen Empfangssignals, das ein an einem Fehlerort eines Kabels erzeugtes akustisches Signal beinhaltet, sowie eine Vergleichseinheit (11) mit einem Speicher (12) aufweist, zum Vergleichen des Empfangssignals mit in dem Speicher (12) gespeicherten Signalmustern oder Merkmalen oder Merkmalsätzen von an einem Fehlerort erzeugten akustischen Signalen, und zum Identifizieren des Signals in dem Empfangssignal, wenn das Signal mit den Signalmustern oder Merkmalen oder Merkmalsätzen eine Übereinstimmung oder eine vorbestimmte Ähnlichkeit aufweist.

7. Vorrichtung nach Anspruch 6,
bei der die Sensor- und Auswerteeinheit (4) einen elektromagnetischen Sensor (42) zum Erfassen eines elektrischen Impulses aufweist, das zum Auslösen des an dem Fehlerort erzeugten akustischen Signals in das Kabel eingespeist wird, wobei die Sensor- und Auswerteeinheit (4) zum Ermitteln einer zeitlichen Verzögerung zwischen dem erfassten elektromagnetischen Signal und dem identifizierten akustischen Signal vorgesehen ist.

8. Vorrichtung nach Anspruch 7,
bei der die Sensor- und Auswerteeinheit (4)
- einen Analog/Digitalwandler (43) zur Digitalisierung des Empfangssignals und des elektromagnetischen Signals,
- einen Signalprozessor (44) zum Vergleichen des Empfangssignals mit in dem Speicher (12) gespeicherten Signalmustern oder Merkmalen oder Merkmalsätzen des an dem Fehlerort erzeugten akustischen Signals, und zum Identifizieren dieses Signals in dem Empfangssignal, wenn dieses Signal mit den Signalmustern oder Merkmalen oder Merkmalsätzen eine Übereinstimmung oder eine vorbestimmte Ähnlichkeit hat, sowie zum Ermitteln einer zeitlichen Verzögerung zwischen dem erfassten elektromagnetischen Signal und dem identifizierten akustischen Signal, sowie
- eine Anzeige- oder Ausgabeeinrichtung (45) aufweist, mit der die zeitliche Verzögerung angezeigt bzw. ausgegeben wird.

9. Vorrichtung nach Anspruch 8,
bei der die Sensor- und Auswerteeinheit (4) zur Ermittlung und Anzeige einer Entfernung zwischen einem momentanen Ort der Sensor- und Auswerteeinheit (4) und dem Fehlerort des Kabels auf der Grundlage der zeitlichen Verzögerung zwischen dem erfassten elektromagnetischen Signal und dem identifizierten akustischen Signal sowie der Ausbreitungsgeschwindigkeit des akustischen Signals vorgesehen ist.

10. Vorrichtung nach Anspruch 6,
mit einem Analysator (10), mit dem das Empfangssignal in eine zeitliche Folge von Merkmalen zerlegt wird, die mit den gespeicherten Signalmustern oder Merkmalen oder Merkmalsätzen verglichen werden.
